Europäisches Patentamt

European Patent Office

Office européen des brevets

(11) Publication number: **0 036 780**
**B1**

(12) **EUROPEAN PATENT SPECIFICATION**

(45) Date of publication of patent specification: **18.06.86**

(51) Int. Cl.⁴: **H 01 L 31/18, H 01 L 27/14**

(21) Application number: **81301239.0**

(22) Date of filing: **23.03.81**

(54) Method of producing photoelectric transducers.

(30) Priority: **24.03.80 JP 36056/80**

(43) Date of publication of application:
**30.09.81 Bulletin 81/39**

(45) Publication of the grant of the patent:
**18.06.86 Bulletin 86/25**

(84) Designated Contracting States:
**DE FR GB NL**

(56) References cited:
FR-A-2 014 490
FR-A-2 119 930
FR-A-2 371 524
FR-A-2 433 871
US-A-4 086 555

SOLID STATE TECHNOLOGY, vol. 13 no. 12,
December 1970. Port Washington New York
(USA); O. CHRISTENSEN: "Characteristics and
applications of bios sputtering", pages 39-45

METAL FINISHING, vol. 72 no. 3, March 1974.
HACKENSAR New York (USA); L.B.LEDER:
"Fundamental parameters of ion plating",
pages 41-45

(73) Proprietor: **Hitachi, Ltd.**
**5-1, Marunouchi 1-chome**
**Chiyoda-ku Tokyo 100 (JP)**

(72) Inventor: **Shimomoto, Yasuharu**
**2196-92 Hirai Hinodecho Nishitama-gun**
**Tokyo (JP)**
Inventor: **Tsukada, Toshihisa**
**Ko-704-17-B405 Sekimachi-4-chome Nerima-ku**
**Tokyo (JP)**
Inventor: **Sasano, Akira**
**2196-450 Hirai Hinodecho Nishitama-gun**
**Tokyo (JP)**
Inventor: **Tanaka, Yasuo**
**217 Higashikoigakubo-1-chome**
**Kokubunji-shi (JP)**
Inventor: **Yamamoto, Hideaki**
**32A404 Koyasumachi-2-chome**
**Hachioji-shi (JP)**
Inventor: **Takasaki, Yukio**
**47-3 F404 Akatsukicho-1-chome**
**Hachioji-shi (JP)**

(74) Representative: **Paget, Hugh Charles Edward**
**et al**
**MEWBURN ELLIS & CO. 2/3 Cursitor Street**
**London EC4A 1BQ (GB)**

## Description

This invention relates to method of producing a photoelectric transducer or solid state image pickup device formed by a photoconductive layer on a semiconductor substrate.

The principle of the solid state image pickup device is that a plurality of picture elements each having at least a photoelectric transducing portion are arranged in a matrix shape and information at each picture element is read by XY address system.

The photoelectric transducing portion of each element is constructed by, for example, directly forming an impurity diffused region in a silicon substrate, or using a photoconductive layer thereon.

In the example of using a photoconductive film, a scanning circuit with, for example, MOS transistors and so on for XY addressing is formed in a silicon Si substrate and then a photoconductive layer is formed on the upper layer of the silicon Si substrate to build up a light receiving portion. Such a solid state image pickup device is seen in Japanese Patent Laid-Open (Kokai) No. 95720/1976, International Electron Devices Meeting, December, 1979, p. 134 to 136, and so on. Moreover, a solid state image pickup device utilizing hydrogenerated amorphous silicon for photoconductive layer is disclosed in GB—A—2029642

It is known, from US—A—4,025,339 and US—A—4,086,555, to produce a photosensitive element by depositing a photoconductive layer on a substrate in an atmosphere containing a plasma while applying an electrical bias to the substrate or a substrate support. In US—A—4,086,555 the photosensitive element is a photoconductive sensor and the substrate is monocrystalline calcium or barium fluoride. The photoconductive layer is $Pb_{1-x}Sn_xTe$ and the bias, which may range from +30 V to −30 V is used in conjunction with a dopant gas (O or N) to control the conductivity type and carrier density of the resultant photoconductive layer. In US—A—4,025,339 the photosensitive element is an electrophotographic film for xerographic, electrofax or camera use and the substrate is an insulating layer e.g. a polyester sheet bearing an ohmic layer e.g. of indium oxide. Cadmium sulphide is recommended for the photoconductive layer, though zinc indium sulphide, arsenic trisulphide, zinc selenide, zinc sulphide, zinc telluride, cadmium selenide, cadmium telluride, gallium arsenide and antimony trisulphide are also suggested. The bias, which is substantially less than −200 V, is stated to cause the deposited molecules of the photoconductive layer to be deposited in a particularly structured manner and exceptional never achieved or predicted electrical properties are said to result from this.

It is disclosed in US—A—4,173,661 (equivalent to FR—A—2,371,524) and in "Characteristics and Applications of Bias Sputtering" (Solid State Technology December 1970 volume 13 number 12 page 39) that a negative substrate bias voltage can improve the purity of a deposited semiconductor layer.

In GB—A—1,269,408 (equivalent to FR—A—2,014,490) it is disclosed that in the deposition of insulating films on integrated monolithic circuit devices, an induced negative potential of at least −60 V on the insulating layer as it is deposited assists in coating the sides of irregularities in the coated surface such as metal conductor lines, so as to provide good edge protection and avoid edge attack in subsequent etching.

The basic idea of this invention is that when a photoconductive layer is deposited on a semiconductor substrate in which a predetermined scanning circuit or the like is formed, by reactive sputtering, or glow discharge CVD (chemical vapor deposition), or under the condition in which at least plasma exists in the atmosphere, a negative bias voltage relative to ground is applied to the above semiconductor substrate. This processing makes the photoconductive layer be smoothly deposited onto the irregular, or uneven portion of the semiconductor substrate, and thereby prevents the photoconductive layer from breaking, or disconnecting at the irregular portion or surface.

Accordingly, the present invention provides a method as set out in claim 1. Usually the substrate is placed on an electrode to which the said negative potential is applied. Typically the photoconductive layer will be amorphous silicon, which may contain hydrogen and also other elements.

An embodiment of the present invention, given by way of example, will now be described with reference to the accompanying drawings, in which:—

Fig. 1 shows the principle of a solid state image pickup device;

Fig. 2 is a cross-sectional view of a semiconductor substrate;

Fig. 3 is a cross-sectional view of a picture element of a solid state image pickup device using a photoconductive layer;

Fig. 4 is an explanatory diagram showing the state of a photoconductive layer deposited by the conventional method;

Fig. 5 is a diagram showing the relation between the substrate and sputtered particles;

Fig. 6 is a graph showing the relation between the incident angle of particles and etching speed;

Figs. 7 to 9 and 11 are explanatory diagrams showing the deposited state by the method of the invention;

Fig. 10 is a schematical diagram of a sputtering apparatus;

Fig. 12 shows dark current characteristics;

Fig. 13 is an explanatory diagram showing the way in which DC bias voltage is applied; and

Fig. 14 is a schematical diagram of a glow discharging apparatus.

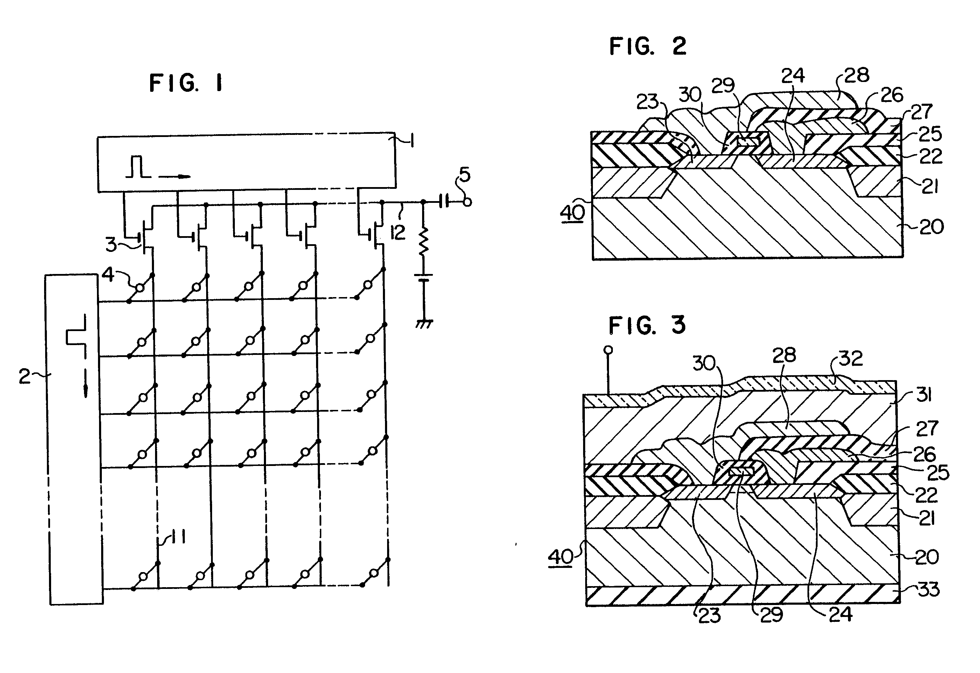

Fig. 1 shows the principle of the solid state image pickup device. Picture elements 4 are arranged in a checked pattern and read from one by one by the XY address system. The selection of each picture element is performed by a horizontal scanning signal generator 1 and a vertical scanning signal generator 2. Reference numeral 3 represents a switch connected to each picture element, and 5 an output terminal. Fig. 2 is a schematical cross-section of a picture element to which reference is made in explaining the principle of the solid state image pickup device using a photoconductive layer. Diffused regions 23 and 24 are provided in a silicon Si substrate 20 to serve as the source and drain of the MOS switch. Reference numeral 29 represents a gate electrode of the MOS switch, 26 a drain electrode thereof from which a signal is taken out, and 28 a source electrode thereof. On the top surface of such a switch circuit are formed a photoconductive thin film 31 and a transparent electrode 32 as shown in Fig. 3. The details of Fig. 2 will be described later. Although CCD (charge coupled device) or the like is formed in a silicon substrate for a scanning circuit as in the prior art, this invention can be applied to the scanning circuit independent of its construction.

The electrode 28 is opposed via the photoconductive film 31 made of photoconductive substance such as $Sb_2S_3$, CdS, $As_2Se_3$, or polycrystalline silicon Si, to the transparent conductive film 32 to form a capacitance C the magnitude of which is proportional to the area, S of the electrode. Since the electrodes are separately arranged in a matrix pattern, the capacitances formed on the electrodes are in a matrix shape. These capacitances each having a photoconductive thin film 31 serve as photosensitive elements, i.e., form picture elements. The photosensitive elements can be replaced by an equivalent circuit which is a parallel circuit of a capacitance C and a variable resistance R depending on the light intensity.

When an optical image is focused via a lens onto the surface of the photoconductive layer, the resistances of the photoconductive film are changed in value in proportional to the light intensity of each part of the optical image. Consequently, at one end 7 of the vertical switch 4 appears a voltage change corresponding to the optical image. This voltage variation is derived through signal output lines 11 and 12 from the output terminal 5, as a video signal.

However, such a photoelectric transducer as described above has a greatly irregular surface of silicon substrate on which a photoconductive film is formed. This is because MOS transistors, CCD or the like are fabricated in the silicon substrate as described previously. The surface irregularity is 1.5 μm, at maximum.

The photoconductive film is generally formed by vacuum evaporation, sputtering evaporation, reactive sputtering, glow discharge CVD, or the like, but it is affected by the irregularity of the silicon substrate surface to have many breaks and pinholes particularly around most irregularities. Thus, the solid state imager having such a light receiving surface will provide a formed image having a greater number of flaws or defects which results in an extremely poor picture quality. In the worst case, a short circuit may be formed between the transparent electrode on the photoconductive film and the lower electrode on the silicon substrate.

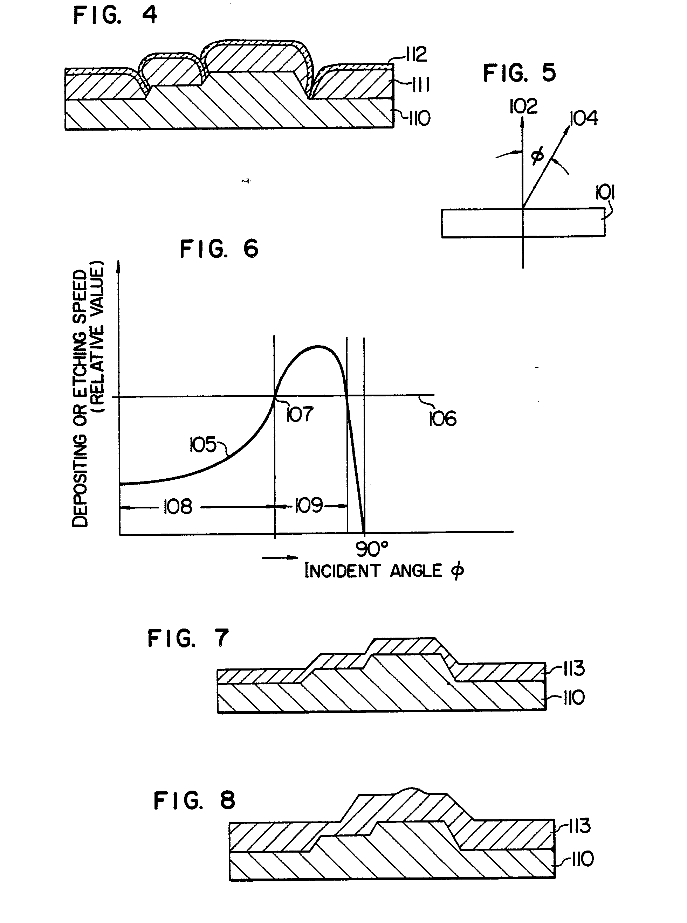

Fig. 4 illustrates this condition. Here, reference numeral 110 represents a semiconductor substrate in which switching elements and scanning circuits are formed. The irregularities on the substrate are due to the wiring and lead conductors of semiconductor elements and so on. If a photoconductive film is deposited on the irregular surface by the normal process, discontinuous points will easily occur particularly at steps of the semiconductor substrate as shown in Fig. 4 at a layer 111. Therefore, when a transparent electrode 112 is formed on the photoconductive layer 111, the lower electrodes exposed on the substrate will be apt to contact the transparent electrode.

This invention proposes a method of forming a photoconductive film with the above drawbacks obviated.

The basic idea of this invention is that when a photoconductive layer is deposited on a semiconductor substrate in which a predetermined scanning circuit or the like is formed, by reactive sputtering, or glow discharge CVD (chemical vapor deposition) at least under the condition in which plasma exists in the atmosphere, a negative bias voltage is applied to the above semiconductor substrate. This processing makes the photoconductive layer be smoothly deposited onto the irregular, or uneven portion of the semiconductor substrate, and thereby prevents the photoconductive layer from breaking, or disconnecting at the irregular portion or surface. This invention can also be applied to, for example, ion plating method by which a photoconductive layer is formed.

The reason why the method of the invention is effective to restrict the occurrence of breaks of the deposited photoconductive film at the steps or irregularities of the substrate, or to make the photoconductive film surface flat, will now be described briefly.

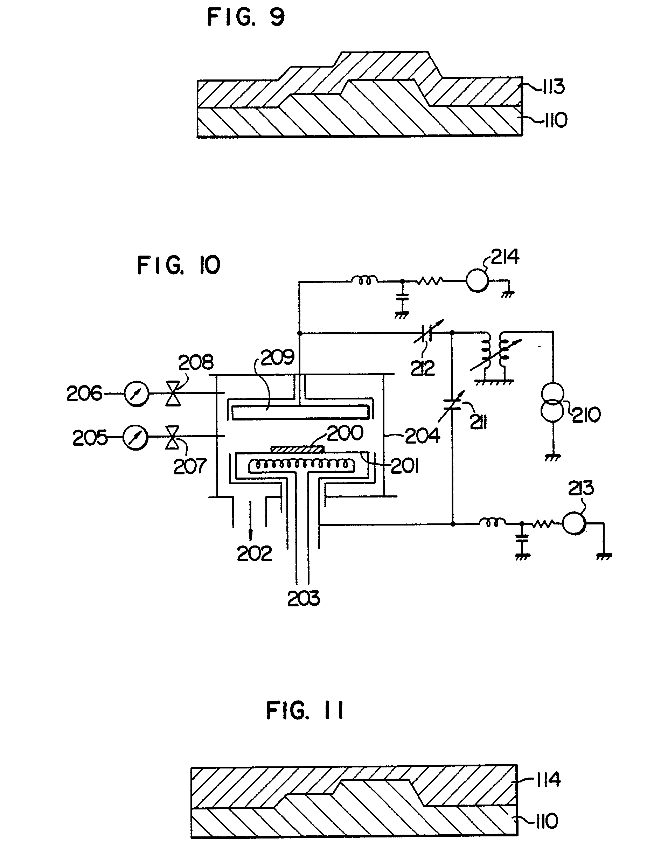

Fig. 5 shows the relation between a sample 101 to be sputtered on and incident particles 104, or the condition in which particles 104 are incident to the sample 101 at angle φ (incident angle) with respect to the normal 102 to the sample surface. Fig. 6 shows the relation between the sputter etching speed and incident angle (φ) of particles, or a curve 105. A straight line 106 represents the depositing speed of particles to be deposited onto the substrate. If, now, a bias voltage is applied to the substrate holder, the relative speed 105 at which the deposited film is sputter-etched, intersects the depositing speed 106 of particles onto the substrate at 107, so that two regions 108 and 109 are produced with the boundary at the intersection. In other words, in the large-φ region, the etching speed is higher than the depositing speed. Therefore, the depositing speed is remarkably reduced at the slopes which are formed between steps on the substrate with the result that the layer is deposited along the slope to be high above the lower flat level. This prevents the layer from breaking at the steps. Figs. 7 to 9 show such state of deposition: Fig. 7 shows the initial state, Fig. 8 the midway state and Fig. 9 the completed state. Although the reason why the photoconductive film is smoothed, has been described for the sputtering method, the photoconductive film can be smoothed by the same mechanism for other methods to which this invention can be applied.

This invention will hereinafter be described for the case in which an amorphous silicon containing hydrogen is used as the photoconductive film. Of course, other photoconductive films can be deposited in the atmosphere containing plasma by the method of this invention: for example, various kinds of chalcogen compounds.

A silicon substrate in which switching circuits, scanning circuits and the like are formed, is first prepared. The switching circuits and so on are satisfactorily formed in the semiconductor substrate by the normal process for semiconductor devices.

Fig. 2 is a cross-section of the semiconductor substrate of a photoelectric transducer using a MOS field effect transistor as a switching element for one picture element region. Reference numeral 20 represents the P-type silicon substrate, 21 an impurity region provided for good isolation between elements, 22 an insulating film such as $SiO_2$, 23 and 24 the impurity diffused regions as source and drain regions, respectively, 25 an insulating film such as $SiO_2$, 26 the drain electrode, 27 an interlayer insulating film, 28 the source electrode, and 29 and 30 the gate electrode and a gate insulating film.

A semiconductor substrate 40 prepared is placed on the substrate holder of the sputtering apparatus, and a bias voltage is applied to the sample holder, during which the photoconductive film 31 is formed by the sputtering method. The thickness of the photoconductive film 31 is generally in the range from 0.5 to 4 μm, or preferably about from 1.5 to 3.0 μm. Moreover, the transparent electrode 32 is formed on the photoconductive film 31, and a second electrode on the other surface of the semiconductor substrate, thus a photoelectric transducer being fabricated. The transparent electrode is formed by depositing a film of indium oxide and tin oxide to about 150 μm thickness, or a very thin film of gold or the like or metal strip film. On a part of the transparent electrode but not the light receiving portion is evaporated via a mask, Cr-Au compound, and to the evaporated area is wire-bonded a biasing electrode. Thus, a solid-state image pickup device is completed. Fig. 3 is a cross-section of this image pickup device.

The sputtering process using biasing according to the invention will be described below.

The amorphous silicon containing hydrogen has the following constituents.

It contains 50-atom percent or above silicon and 5-to-50 atom percent hydrogen. The hydrogen content is preferably 5 to 30 atom percent. The silicon may be replaced by Ge or C to about 30% in general. The thickness of the photoconductive layer is generally from 0.5 μm to 4 μm.

Of course, an impurity is added as necessary.

The hydrogen containing amorphous silicon film is formed by the reactive sputtering method as follows. A molten silicon or crystal silicon is used as a target in the atmosphere of the mixture of an inert gas, generally argon Ar and a necessary amount of $H_2$ gas, in which atmosphere glow discharge is caused by direct current or high frequency. Thus, argon ions $Ar^+$ are bombarded to the target in the glow discharge to be deposited on the substrate opposite to the target. The silicon atoms Si ejected from the target react with hydrogen atoms H to form a desired amorphous silicon Si film containing hydrogen. Another inert gas Ne, Kr, or Xn and $PH_3$ or $B_2H_5$ gas may be used instead of the mixture gas of Ar and $H_2$. The discharge gas pressure is selected to be in the range from $8 \times 10^{-5}$ to $5 \times 10^{-2}$ Torr. For stable discharge it is preferred to select the range from $1 \times 10^{-4}$ to $1 \times 10^{-2}$ Torr (1 Torr = 133 Pa).

The substrate temperature during deposition may be the temperature at which the general sputtering is performed. For the hydrogen containing silicon, selection is made between 50° and 300°C, and it is preferred to select between 150 and 250°C. Selection of too low temperature will cause unstable coupling between Si and H in the hydrogen containing silicon film, resulting in deterioration of the photoconductive characteristics.

A negative potential is applied to the substrate holder.

Fig. 10 is a schematical diagram useful for explaining the bias sputtering apparatus. Reference numeral 204 represents a vacuum container generally called a sputter chamber. The air of the sputter chamber is exhausted from an exhaust portion 202 to less than $1 \times 10^{-6}$ Torr at most. After exhaustion of air, argon and hydrogen are supplied from gas flow inlets 205 and 206 via gas control valves 207 and 208 to the sputter chamber. Reference numeral 209 represents a target to be sputtered to and this target 209 is opposed to a substrate holder 201. Reference numeral 203 represents substrate heating means such as heater, and 200 is a semiconductor substrate as a sample. During sputtering, the substrate holder 201 and target 209 are supplied with a high-frequency power. Usually, the high frequency power from a high frequency power source 210 (generally 13.56 MHz) is applied to the substrate holder 201 and the target 209 via capacitors 211 and 212. The power to be supplied is selected to be in the range from 0.1 to 10 watt/$cm^2$, and the ratio of power to be supplied to the substrate to that to the target is in the range from 1/6 to 1/10. Consequently, the thickness of the photoconductive film is highly uniform as shown in Fig. 9, in which a uniform-thickness photoconductive film 113 is formed on the semiconductor substrate 110. In this case, the electric field to be established when the solid state image pickup device operates is satisfactorily uniform in the photoconductive film. The power ratio is usually selected to be 1/6 or 1/8.

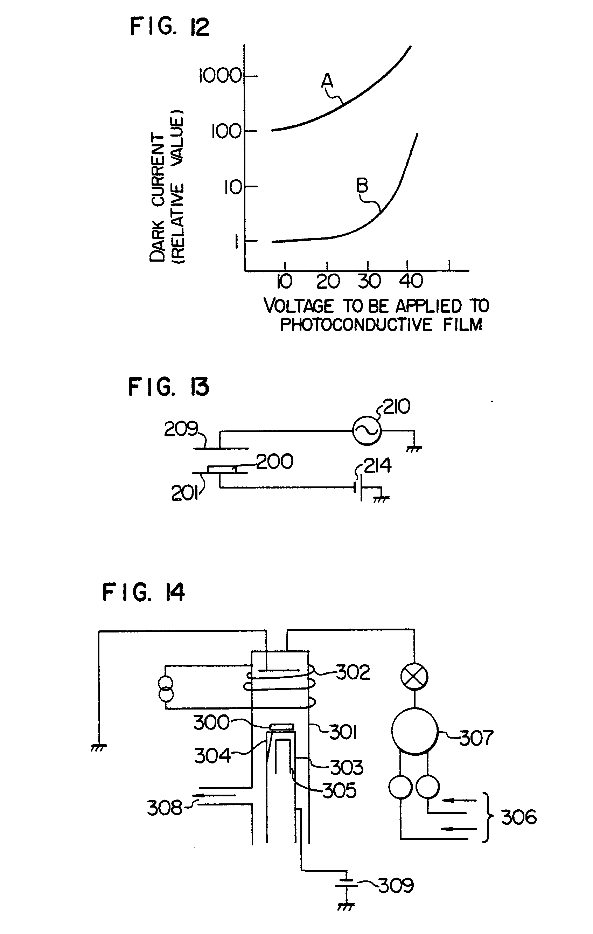

On the other hand, as the voltage ratio approaches to 1/1, the surface itself of the photoconductive film becomes flat from the macro-standpoint, as shown in Fig. 11, in which a photoconductive film 114 of flat surface is formed on the semiconductor substrate 110. Therefore, the transparent electrode is provided with ease on the photoconductive film. However, when a voltage is applied to the photoconductive film 114, the electric field strength at each position is different due to ununiform thickness of the film.

Reference numerals 213 and 214 designate volt meters for the substrate holder and target, respectively. To the substrate holder is applied a voltage usually in the range from $-5$ V to $-300$ V. For example, under the conditions of discharge power, 2 $W/cm^2$, hydrogen partial pressure, $5 \times 10^{-4}$ Torr in the atmosphere, argon partial pressure, $2 \times 10^{-3}$ Torr and biasing voltage $-50$ V to the sample holder, hydrogenated amorphous silicon layer of about 3 μm is formed in three hours.

Fig. 12 shows the dark currents in the photoelectric transducer according to the invention and the conventional counterpart: Curve A indicates the conventional and curve B the invention. The photoconductive film is an amorphous silicon containing hydrogen silicon (15%) and the thickness is 2.0 μm. From the figure it will be seen that the photoelectric transducer according to the invention ·is very excellent in the dark current characteristic. This is chiefly because the breaks of the photoconductive film at the step have been obviated.

The reactive sputtering may be made by DC (direct current) instead of RF sputter. For this DC reactive sputtering a voltage of about $-2$ to $-7$ kV is applied to the target. The other things may be considered substantially the same as above. Fig. 13 shows the way in which DC bias is applied. Reference numeral 200 represents the sample, 201 the sample holder, 209 the target, 210 the sputtering high-frequency power source, and 214 a biasing DC power source.

In order that the photoconductive film of the photoelectric transducer or solid state image pickup device has a requisite thickness for flat surface, it is unnecessary to make full use of the method of the invention. For example, the method of this invention is utilized for first part of the thickness of the photoconductive film, as a sputtered film for deposition enough to flatten the sides of the underlying irregularities, and then the other part of the thickness of the photoconductive film is grown as a second layer by a conventional deposition method for the consideration of photoconductive characteristics. In this case, the necessary film thickness to be obtained by the method of the invention is in the range from 0.5 to 2.0 μm.

On the contrary, part of the thickness of the complete photoconductive film may be achieved on the semiconductor substrate by the normal method and then the other part of the thickness by the method of the invention. Of course, the photoconductive film may be in three or more layers in order to attain the complete thickness, but the photoconductive film must be deposited to a thickness of 0.5 to 2.0 μm by the method of the invention.

The method of depositing photoconductive film on a substrate to which a bias is applied may be utilized for the case where a hydrogen containing silicon film is formed by decomposition of $SiH_4$ or the like in the glow discharge. Fig. 14 shows an example of using the glow discharge. Reference numeral 300 denotes a sample, 301 a container which can be evacuated to a vacuum, 302 an rf coil, 303 a sample holder, 304 a temperature measuring thermocouple, 305 a heater, 306 an inlet through which an atmosphere gas such as $SiH_4$ or the like is introduced, 307 a tank for mixing gases and 308 a connection to an exhaust system. The method in which decomposition due to glow discharge is utilized, may be a normal one. Numeral 309 represents a power supply for supplying a bias to the substrate. This bias has an effect similar to that of the sputtering method.

Ar gas and $SiH_4$ gas are introduced into the vacuum container. In this case, Ar gas is not necessarily used. The ratio of $SiH_4$ gas to Ar gas is 10 vol.% or above, and the gas pressure of the row material gas is in the range between $10^{-2}$ to 3 Torr. The substrate is maintained at temperature of 200°C and normally a high frequency of 0.2 to 30 MHz is applied to cause glow discharge in the atmosphere so that the hydrogen containing silicon film is formed on the substrate to a thickness of 2.0 μm. The subsequent processes are similar to the above example. Also in this case, bias of $-50$ V is applied to the substrate to enable an excellent hydrogenated amorphous silicon layer to be formed, and thus a photoelectric transducer with a small dark current can be realized.

**Claims**

1. A method of producing a photoelectric transducer in which a photoconductive layer is formed on a semiconductor substrate having an insulating material layer thereon, there being impurity-doped regions in the semiconductor substrate and electrodes contacting at least a part of the impurity-doped regions to form semiconductor switch elements, the photoconductive layer being formed by deposition in an atmosphere containing a plasma and the substrate being located opposite to a further electrode and being at a negative electrical potential relative to ground for at least a part of the deposition process, which negative potential is in the range of $-5$ V to $-300$ V, the ratio of power supplied to the substrate to power supplied to the further electrode opposite the substrate being in the range of 1/6 to 1/10 whereby the photoconductive layer deposited is continuous and free of breaks even if the substrate surface onto which it is deposited is uneven.

2. A method according to claim 1 in which the substrate is placed on an electrode to which the said negative potential is applied.

3. A method according to claim 1 or claim 2 in which the photoconductive layer comprises amorphous silicon.

4. A method according to claim 3 wherein the photoconductive layer comprises amorphous hydrogen-containing silicon.

5. A method according to any one of claims 1 to 4 wherein the photoconductive layer is formed by sputtering, and a target is placed on said further electrode.

6. A method according to claim 5 wherein the sputtering is reactive sputtering.

7. A method according to any one of claims 1 to 4 wherein the photoconductive layer is formed by glow discharge in an atmosphere including raw material gas for the layer.

8. A method according to any one of the preceding claims wherein the substrate is at the said negative potential while a predetermined thickness constituting part of said photoconductive layer is formed.

9. A method according to any one of the preceding claims in which the said ratio of powers is in the range of 1/6 to 1/8.

10. A method according to any one of the preceding claims in which an electrical bias potential is applied to the said further electrode opposed to the substrate, which bias potential has a greater magnitude than the said negative potential of the substrate.

**Revendications**

1. Procédé pour fabriquer un transducteur photoélectrique, selon lequel on forme une couche photoconductrice sur un substrat semiconducteur revêtu par une couche de matériau isolant, et il est prévu des régions dopées par une impureté dans le substrat semiconducteur, et des électrodes contactant au moins une partie des régions dopées par une impureté de manière à former des éléments de commutation à semiconducteurs, la couche photoconductrice étant formée au moyen d'un dépôt dans une atmosphère contenant un plasma et le substrat étant situé en vis-à-vis d'une électrode supplémentaire et étant placé à un potentiel électrique négatif par rapport à la masse pendant au moins une partie du processus de dépôt, lequel potentiel négatif se situe dans la gamme de −5 V à −300 V, et le rapport de l'énergie envoyée au substrat à l'énergie envoyée à l'électrode supplémentaire placée en vis-à-vis du substrat étant compris dans la gamme de 1/6 à 1/10, ce qui a pour effet que la couche photoconductrice déposée est continue et n'a pas d'interruption même si la surface du substrat sur laquelle elle est déposée, n'est pas unie.

2. Procédé selon la revendication 1, selon lequel on place le substrat sur une électrode, à laquelle ledit potentiel négatif est appliqué.

3. Procédé selon la revendication 1 ou 2, selon lequel la couche photoconductrice comporte du silicium amorphe.

4. Procédé selon la revendication 3, selon lequel la couche photoconductrice comporte du silicium amorphe contenant de l'hydrogène.

5. Procédé selon l'une quelconque des revendications 1 à 4, selon lequel la couche photoconductrice est formée par pulvérisation et une cible est placée sur ladite électrode supplémentaire.

6. Procédé selon la revendication 5, selon lequel la pulvérisation est une pulvérisation réactive.

7. Procédé selon l'une quelconque des revendications 1 à 4, selon lequel la couche photoconductrice est formée par une décharge luminescente dans une atmosphère contenant un gaz contenant de la matière première pour la couche.

8. Procédé selon l'une quelconque des revendications précédentes, selon lequel le substrat est placé audit potentiel négatif pendant la formation d'une couche d'une épaisseur prédéterminée constituant une partie de ladite couche photoconductrice.

9. Procédé selon l'une quelconque des revendications précédentes, selon lequel ledit rapport des énergies se situe dans la gamme comprise entre 1/6 et 1/8.

10. Procédé selon l'une quelconque des revendications précédentes, selon lequel un potentiel de polarisation électrique est appliqué à ladite électrode supplémentaire située en vis-à-vis du substrat, lequel potentiel de polarisation possède une valeur supérieure audit potentiel négatif du substrat.

**Patentansprüche**

1. Verfahren zur Herstellung eines photo-elektrischen Wandlers, bei dem auf einem Halbleitersubstrat mit einer darauf vorgesehenen Schicht aus Isoliermaterial eine photo-leitfähige Schicht ausgebildet wird, wobei störstoffdotierte Bereiche in dem Halbleitersubstrat und mindestens einen Teil der störstoffdotierten Bereiche kontaktierende Elektroden vorhanden sind, um Halbleiter-Schaltelemente zu bilden, wobei die photo-leitfähige Schicht durch Niederschlag in einer ein Plasma enthaltenden Atmosphäre erzeugt und das Substrat mindestens während eines Teils des Niderschlagsvorgangs gegenüber einer weiteren Elektrode angeordnet und auf einem bezüglich Erde negativen elektrischen Potential im Bereich von −5 V bis −300 V gehalten wird, wobei das Verhältnis der dem Substrat zugeführten Energie zu dem der weiteren Elektrode gegenüber dem Substrat zugeführten Energie im Bereich von 1/6 zu 1/10 liegt, so daß die niedergeschlagene photo-leitfähige Schicht auch dann kontinuierlich und frei von Brüchen ist, wenn die Substratoberfläche, auf die sie niedergeschlagen wird, uneben ist.

2. Verfahren nach Anspruch 1, bei dem das Substrat auf einer Elektrode angeordnet wird, an die das negative Potential angelegt wird.

3. Verfahren nach Anspruch 1 oder 2, bei dem die photo-leitfähige Schicht amorphes Silicium enthält.

4. Verfahren nach Anspruch 3, bei dem die photo-leitfähige Schicht wasserstoffhaltiges amorphes Silicium enthält.

5. Verfahren nach einem der Ansprüche 1 bis 4, bei dem die photo-leitfähige Schicht durch Sputtern erzeugt und auf der weiteren Elektrode ein Target angeordnet wird.

6. Verfahren nach Anspruch 5, bei dem es sich bei dem Sputtern um Reaktiv-Sputtern handelt.

7. Verfahren nach einem der Ansprüche 1 bis 4, bei dem die photo-leitfähige Schicht durch Glimmentladung in einer das Ausgangsmaterial für die Schicht in Gasform enthaltenden Atmosphäre erzeugt wird.

8. Verfahren nach einem der vorhergehenden Ansprüche, bei dem das Substrat auf dem negativen Potential gehalten wird, während ein vorgegebener, eine Dicke bestimmender Teil der photoleitfähigen Schicht erzeugt wird.

9. Verfahren nach einem der vorhergehenden Ansprüche, bei dem das Energieverhältnis im Bereich von 1/6 bis 1/8 liegt.

10. Verfahren nach einem der vorhergehenden Ansprüche, bei dem an die weitere Elektrode gegenüber dem Substrat ein elektrisches Vorspannungspotential engelegt wird, das einen größeren Betrag hat als das negative Potential des Substrats.

FIG. 1

FIG. 2

FIG. 3

0 036 780

FIG. 4

~112
~111
~110

FIG. 5

102
104
φ
101

FIG. 6

DEPOSITING OR ETCHING SPEED
(RELATIVE VALUE)

107
105
106
108 | 109
90°
INCIDENT ANGLE φ

FIG. 7

113
110

FIG. 8

113
110

0 036 780

## FIG. 9

~113
~110

## FIG. 10

206 — 208 — 209
205 — 207 — 200 — 204 — 201
202
203
214 — 212 — 211 — 210 — 213

## FIG. 11

~114
~110

3

FIG. 12

DARK CURRENT (RELATIVE VALUE)

1000
100
10
1

A

B

10   20   30   40

VOLTAGE TO BE APPLIED TO
PHOTOCONDUCTIVE FILM

FIG. 13

FIG. 14

4